Europäisches Patentamt

European Patent Office

Office européen des brevets

(11) Publication number: 0 349 325
A2

# EUROPEAN PATENT APPLICATION

(21) Application number: 89306628.2

(22) Date of filing: 29.06.89

(51) Int. Cl.⁵: **G 11 B 20/10**
**H 04 N 5/92, H 03 M 13/00,**
**H 04 L 1/00**

(30) Priority: 30.06.88 JP 163667/88

(43) Date of publication of application:
03.01.90 Bulletin 90/01

(84) Designated Contracting States: DE ES FR GB NL

(71) Applicant: **SONY CORPORATION**
**7-35 Kitashinagawa 6-Chome Shinagawa-ku**
**Tokyo 141 (JP)**

(72) Inventor: **Odaka, Kentaro c/o Patents Division**
**Sony Corporation 6-7-35 Kitashinagawa Shinagawa-ku**
**Tokyo 141 (JP)**

(74) Representative: **Thomas, Christopher Hugo et al**
**D Young & Co 10 Staple Inn**
**London WC1V 7RD (GB)**

(54) Digital signal transmission apparatus.

(57) A digital signal transmission apparatus in which a digital signal having a header block of a predetermined length is transmitted. The header comprises a synchronization signal and auxiliary data. The auxiliary data is made up of first data or second data and a redundant error detection code. The redundant code is formed so that syndrome patterns of the error detection code are different in order to distinguish the block in which the first data is contained as the auxiliary data on the reception side, from the block in which the second data is contained as the auxiliary data so that a plurality of headers having different contents can be distinguished on the reception side.

Fig. 11

## Description

## DIGITAL SIGNAL TRANSMISSION APPARATUS

This invention relates to digital signal transmission apparatus. The invention is particularly, but not exclusively, suitable for use in recording pulse code modulated (PCM) signals onto a magnetic tape using rotary heads, and for error correction in a digital encoder for recording high quality audio PCM data, as disclosed in US patent specification US-A-4 551 771.

There is a known error correction encoding apparatus and method for use with information symbols arranged two-dimensionally in a matrix form in which encoding processes of error detection and error correction codes, for example Reed-Solomon codes are executed in each of the vertical and lateral directions of the information symbols. These codes are transmitted for each column (referred to as a block) in the vertical direction. On the reception side, the error correction is performed by using a first error detection and error correction code (referred to as a C1 code or a first error detection code) and, at the same time, a pointer indicative of the presence or absence of errors is formed. Next, the errors are corrected by a second error detection and a error correction code (referred to as a C2 code or a second error detection code) in dependence on to this pointer.

In the case where the foregoing error correction encoded data are transmitted for each block, one block of data is formed by the addition of a synchronization signal and a header consisting of auxiliary data such as a block address, a time code, etc. A two-dimensional arrangement is formed by a plurality of blocks. Since redundancy increases when block addresses are added to all blocks, for example, 100 blocks, it is desirable that block addresses should be contained in a part of blocks, and auxiliary data, etc, should be inserted into a part of blocks by omitting the block addresses.

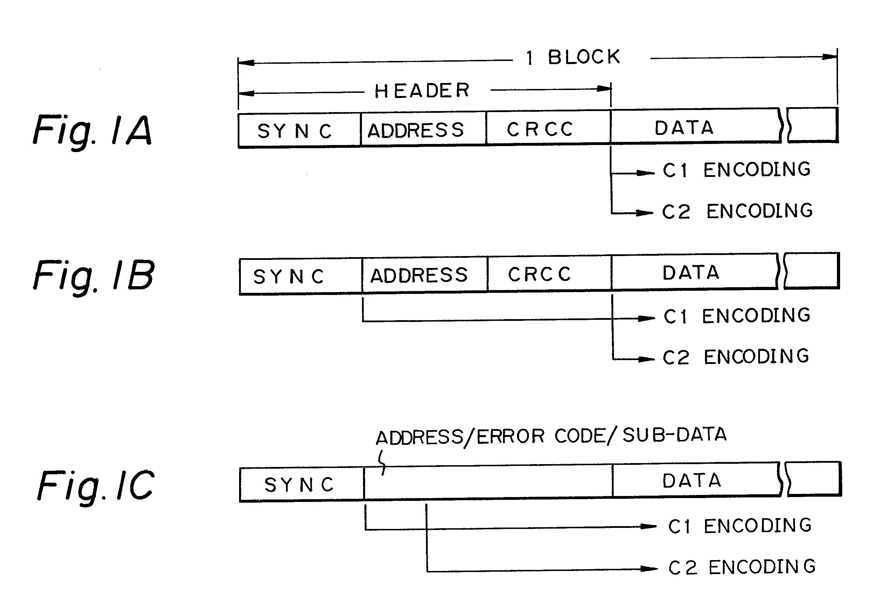

For example, in US patent specification US-A-4 630 272, there is shown a method whereby a sync signal and an address in which error detection can be independently performed by a cyclic redundancy check (CRC) code are added to each column of data and to the parity data of a C1 code, thereby forming one block. In the above US specification, as shown in Figure 1A herein, for the address, the error detection can be executed by the CRC code, and for a data portion (PCM audio signals), encoding processes of a first error correction code (referred to as a C1 code) and a second error correction code (referred to as a C2 code) are performed. In the case of this encoding, however, since the C1 code is not applied to the address, the protection against errors is insufficient.

To solve this problem, for example, as disclosed in US patent specification US-A-4 682 332 and as shown herein in Figure 1B, error correction encoding is proposed in which encoding by a C1 code is also executed for the address.

When a header consists of only an address, the error correction encoding shown in Figure 1B is useful. However, if PCM audio signals (main data) are included in the header in addition to the address, the encoding by the C1 code is only executed for the main data and there is a problem in that the protection for errors is insufficient for a reason to be mentioned later. Encoding by the C2 code of the whole header, including the address, to eliminate this drawback causes an inconvenience in that the data area in which the address are recorded is lost by the existence of the C2 parity.

To solve this problem, as shown in Figure 1C, we have proposed an error correction encoding apparatus in which a whole header together with a data portion is C1 encoded and the encoding of a C2 code is performed for the main data included in the header, excluding addresses, thereby enabling error protection of the part of the main data included in the header to be made strong, so that the main data can be recorded into the header part. The insertion of audio data into the header facilitates the adjustment of synchronization between a picture which is reproduced from the tape and an audio sound, by varying the number of audio data words which are included in a frame of data area. This error correction encoding apparatus is suitable when it is used in an 8-mm video tape recorder (VTR) as disclosed in US patent specification US-A-4 551 771, in which both a video signal of one field and audio PCM signals of one field, that is, time base compressed audio PCM signals are recorded on a magnetic tape by a single scan.

In the already commercialized 8-mm VTR, the sampling frequency of the audio PCM signals is selected to be $2f_h$ (where $f_h$ is the horizontal frequency). Therefore, the rotary heads which rotate at a frame frequency and a sampling system are synchronized, and the problem of asynchronization between an image and an audio sound does not occur. However, there is a problem in that the sampling frequency of the conventional 8-mm VTR is too low where audio signals of a high quality are to be recorded and reproduced. In addition, there is the problem of the absence of matching with the sampling frequencies (44.1 kHz, 48 kHz, 32 kHz, etc) which are used in other digital audio apparatuses such as compact disc (CD) players and rotary head type digital audio tape recorders (R-DATs). Therefore, it is preferable to be able to use those frequencies (44.1 kHz, 48 kHz, 32 kHz, etc) as the sampling frequency of the audio PCM signals in the 8-mm VTR.

However, since there is no integral ratio between the above-mentioned frequency and, for example, the field frequency (59.94 kHz) of the NTSC system, the number of sampling data included in one field period is not an integer. Therefore, when both a video signal and audio PCM signals are recorded on the same track, as in the 8-mm VTR, the problem occurs of asynchronization between the video image and the corresponding audio sound.

Thus, in the case where the sampling frequency cannot be divided by a frequency of an encoded unit, for example, the field frequency, the sample number contained in one frame of a code structure varies over a range of numbers close to the quotient of the division. Data processing on the reception side can be performed without any trouble by transmitting an identification signal indicative of the sample number. The foregoing PCM processor for an 8-mm VTR is disclosed in US patent application number 262 523.

In the above system, a 2-symbol (16 bits) block address is inserted into a header, and a 1-symbol block address is inserted into a block in which a 1-symbol audio PCM signal is contained as auxiliary data. A block in which an audio PCM signal is included into a header is prescribed to have a block address of an odd-number whose least significant bit is "1". However, since the provision of one symbol of a block address to all blocks increases data redundancy, the format in which there are mixed together blocks having block addresses and blocks having data such as an audio PCM signal other than an address but having no block address is desirable. In this case, since no block address is added to the blocks in which data such as an audio PCM signal are inserted, it is impossible to distinguish a header content by the block address.

Therefore, embodiments of the present invention perform an identification of a header content by a redundant code of an error detection code which is added for error detection of the block address, parity code Q, sub-code and PCM signal included in the header only.

Although different from this invention, as a method utilizing a redundant code of an error detection code, it may be considered that one bit of the redundant code is allotted for identification. For example, one bit of an 8-bit redundant code is allotted for identification. In this system, since the redundant code has seven bits, there is the problem that data processing in byte units becomes difficult. Also, when one bit of the eight bits of redundant code is allotted to an identification bit, two kinds of headers corresponding to "0" and "1" can be identified.

By the allotment of two bits to identification bits, four kinds of headers corresponding to the combination of "0" and "1" can be identified. As a result, only multiples of two are given for the identification. In the case of the identification of three kinds, five kinds, etc, a system in which a partial bit of a redundant code is allotted to an identification bit is not suitable.

According to the present invention there is provided a digital signal transmission apparatus for transmitting a digital signal having a header of a predetermined length, wherein said header comprises:
a synchronization signal; and
an auxiliary data signal comprising an error code data signal and a redundant code, said error code data signal being selected from a first error code data signal and second error code data signal;
said redundant code having a syndrome pattern associated with said error code data signal which indicates which of said first error code data signal and said second error code data signal is comprised in said auxiliary data signal.

According to the present invention there is also provided a digital signal transmission apparatus for transmitting a digital signal, wherein said digital signal comprises:
a two-dimensional array of digital data information signals, having a horizontal direction and a vertical direction, and wherein a first error detection code is encoded in said vertical direction to form a first redundant code, and a second error detection code is encoded in said horizontal direction to form a second redundant code, said first and second error detection codes having a syndrome pattern respectively associated therewith; and including:
means for adding a header comprising a synchronization signal and an auxiliary data signal to said digital signal, wherein said auxiliary data signal comprises an error code data signal and a third redundant error detection code, the error code data signal is selected from a first error code signal and a second error code signal wherein said error code data signal is encoded with said first error detection code when said error code data signal is said first error code data signal, and said error code data signal is encoded with said first error detection code and said second error detection code when said error code data signal is said second error code data signal, and wherein said third redundant code is formed so that said syndrome pattern distinguishes said auxiliary data signal including said first error code signal from said auxiliary data signal including said second error code signal.

According to the present invention there is also provided a digital data recording and reproduction apparatus comprising:
an A/D converter for converting an analogue input signal having a field frequency associated therewith into a digital data signal having a sampling frequency associated therewith;
an encoder for adding an error correction code to said digital data signal to generate an encoded digital data signal; and
means for magnetically recording said encoded digital data signal onto a magnetic tape having at least one track, said means for magnetically recording having rotational magnetic heads, wherein:
said encoder generates said error correction code, said error correction code has a data frame arranged as a two-dimensional array having a preselected size, said array size including at least a first word number and a second word number, each of said first and second word numbers being an integral value determined by said sampling frequency of said digital data signal divided by said field frequency;
said data frame has a first plurality of blocks and a second plurality of blocks, said first plurality of blocks comprises a pulse code modulated audio data area and said second plurality of blocks comprises a header area, said header area being composed of a synchronization signal and auxiliary data;
said auxiliary data comprise an error code data signal and a redundant code, said error code data signal being a first error code data signal or a second error code data signal; and said redundant code indicates the error code data signal selected, and said redundant code has a syndrome pattern associated therewith to distinguish said error code data signal selected.

According to the present invention there is also provided a digital data recording and reproduction apparatus, comprising: an A/D converter for converting an analogue input signal having a field frequency associated therewith into a digital data signal having a sampling frequency associated therewith; an encoder for adding an error correction code to said digital data signal, said encoder generating an encoded digital data signal; and means for magnetically recording said encoded digital data signal onto a magnetic tape having at least one track, said means for magnetically recording having rotational magnetic heads; said encoder having a data frame arranged as a two-dimensional array having a preselected size, said array size including at least a first word number and second word number, said first and second word numbers being an integral value determined by said sampling frequency of said digital data signal divided by said field frequency; said two-dimensional array having a vertical direction and a horizontal direction and comprising a plurality of digital data information signals, a first error detection code encoded in the vertical direction to form a first redundant code, a second error detection code encoded in the horizontal direction to form a second redundant code, and a header comprised of a synchronization signal and an auxiliary data signal; said auxiliary data signal comprising a third redundant code and an error code selected from a first error code data signal and a second error code data signal; said first error code data signal is encoded with said first error detection when said auxiliary data signal comprises said first error code data signal and said second error code data signal is encoded with said first error detection code and said second error detection code when said auxiliary data signal comprises said second error code data signal; and said third redundant code has a syndrome pattern associated therewith, said syndrome pattern indicating which of said first error code date signal and said second error code data signal is comprised in said auxiliary data signal.

Thus an embodiment of the present invention may form a digital signal transmission apparatus for transmitting a digital signal having a header which comprises a synchronization signal and auxiliary data for each block of a predetermined length, the auxiliary data being made up of first error code data signal or second error code data signal and a redundant code associated with the first error code data or the second error code data. The redundant code is formed so that syndrome patterns of the error code are different to distinguish during reproduction the block in which the first data is contained as the auxiliary data from the block in which the second data are contained as the auxiliary data, on the reception side.

A header consisting of a synchronization signal, auxiliary data and a redundant code of an error detection code for the auxiliary data is added to each block. Audio PCM signals are recorded as a frame of data unit having a plurality of blocks, for example, a two-dimensional array of symbols. In the two-dimensional array, data of one field of the audio PCM signal are contained. The data of one field are encoded by the C1 code and the C2 code, and a redundant code P of the C1 code and a redundant code of the C2 code are generated.

In the case of the NTSC system, the field frequency is 59.94 Hz, and in the case of a sampling frequency of 48 kHz, the sampling frequency cannot be evenly divided by the field frequency. That is, $48000 \div 59.94 = 800.8$. Integers of two or more which are close to the quotient, for example, 800 and 801 are then chosen.

An identification signal indicative of the number of samples recorded as data of one field is transmitted together with those values. The reception side judges whether the sample number of one field is 800 or 801 from the identification signal. Therefore, even if the number of samples of one field is an integer, the foregoing number of samples which is close to the quotient which is not an integer is recorded on average and the occurrence of asynchronization between a video image and an audio sound can be prevented. In the two-dimensional arrangement of one frame in which the number of samples (or words) is 801, 800 samples are inserted into the data area and the remaining one sample (two samples in the case of two channels L/R) are inserted into a header. With respect to the two samples inserted into the header (four symbols when eight bits are encoded as one symbol in the case of one sample having 16-bit data), the encoding of both C1 code and the C2 can be performed. On the other hand, in a frame having 800 samples (or words), 800 samples are inserted into the data area, and no audio sample is inserted into the header. Therefore, a block with a header having an address signal and a block having no address signal are formed. Both blocks can be discriminated by a redundant code of an error detection code in the header. When a simple parity is employed as an error detection code, the distinction of two headers can be made by the inversion and non-inversion of the parity. The inversion is performed by adding (11111111) to the parity bits.

Therefore, it is possible to set the content of the header of every block desirably, and an audio PCM signal, a time code, etc, can be inserted into the headers. Thus increase of redundancy can be prevented and the degree of freedom of the format increased. Also, 8-bit data processing can be used although it is different from the case where one bit of the redundant code is employed as an identification bit. Further, there is an advantage that there is no need to put a restriction that the kinds to be identified are a multiple of two.

The invention will now be described by way of example with reference to the accompanying drawings, throughout which like parts are referred to by like references, and in which:

Figures 1A, 1B and 1C are schematic diagrams for explaining a previously proposed error correction code;

Figures 2, 3, 4 and 5 are schematic diagrams showing several examples of a frame format to which this invention is applicable;

Figure 6 is a schematic diagram showing a frame format of one embodiment of the invention;

Figures 7A, 7B, 7C, 7D and 8 are schematic diagrams for describing an example of a data interleave;

Figures 9A, 9B, 9C and 9D are schematic diagrams for explaining a block format;

Figure 10 is a schematic diagram for explaining the contents of addresses; and

Figure 11 is a block diagram of one example of a PCM record processing circuit.

The description will be given in the following order:

A. A block format and a frame format
B. An example of data interleave
C. Format of a block
D. PCM recording processing circuit
E. Modifications

## A. A Block Format and a Frame Format

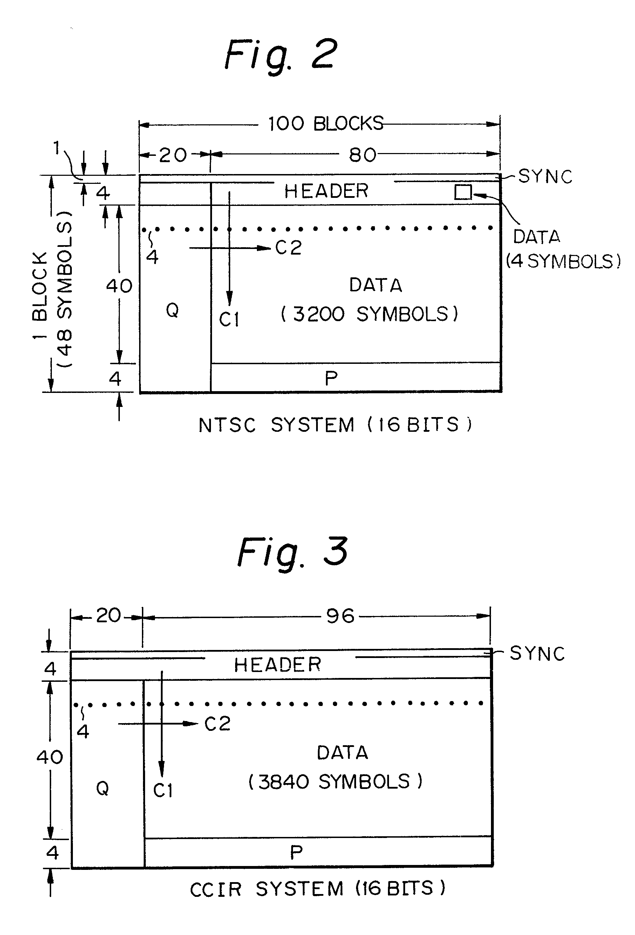

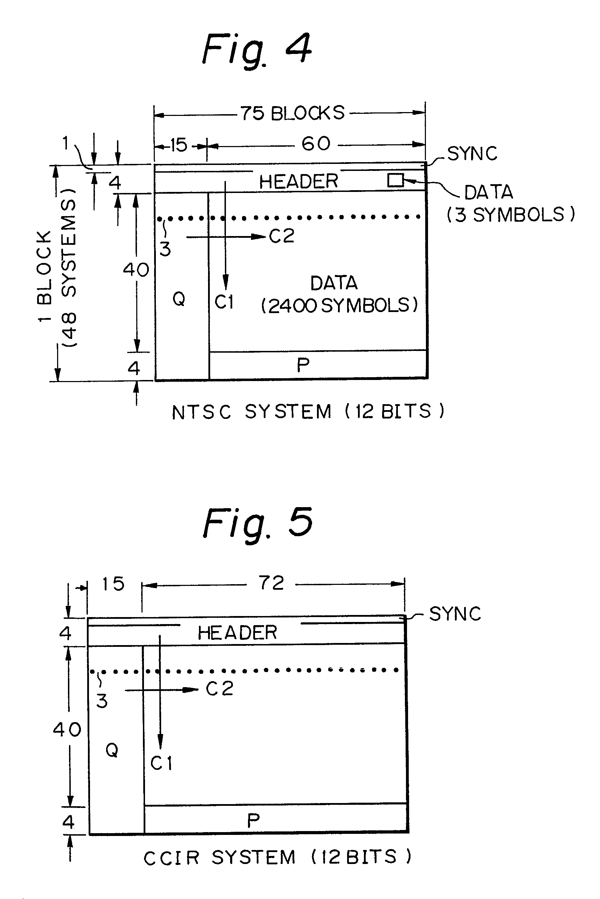

Figures 2 to 5 show several examples of a frame format to which the invention is applicable. Figures 2 and 4 are frame formats which are application to transmission of audio data of one field in the NTSC system. Figure 2 shows a frame format in the case where one word consists of 16 bits, and Figure 4 shows a frame format in the case of 12 bits compressed from 16 bits. Figures 3 and 5 are frame formats applicable to the encoding of audio data of one field in the CCIR system (PAL system or SECAM system). Figure 3 shows a frame format in the case where one word has 16 bits, and Figure 5 shows a frame format in the one-word-16-bit case.

The provision of 12 bits and 16 bits as the bit number of one word is to provide a different recording wavelength depending on the kind of magnetic tape to be used. For example, in the case of an evaporated metal tape, the recording/reproduction of 16-bit data is performed, while the recording/reproduction of 12-bit data is carried out in the case of a metal coating tape.

In the case of the NTSC system, fields having 800 words per channel and fields having 801 words per channel mixedly exist. In the 1-symbol-8-bit case, fields having 3200 ($= 800 \times 2 \times 2$) symbols per two channels L/R, and fields having 3204 ($= 801 \times 2 \times 2$) symbols per two channels L/R mixedly exist. Audio data are arranged in a matrix form of 40 x 80 symbols (or bytes), and four symbols which occur in the transmission of a field having 801 words are inserted into a header. The header includes a synchronization signal to provide 4 x 100 symbols. The encoding of the C1 code is performed in the vertical direction of the two-dimensional array of data and headers, and in the horizontal direction, the encoding of the C2 code is carried out. However, as stated later, no encoding is performed for the C1 code and the C2 code with respect to a synchronization signal. With respect to a redundant code of an error detection code and a part of an auxiliary code in the header, the encoding of only the C1 code is effected. The encoding of the C1 code and the C2 is performed on a sub-code (various ID codes, and so on) of the auxiliary code and audio data (four symbols).

For the C1 code, the Reed-Solomon code whose (code length, information length, distance) are 47, 43, 5, respectively, is employed, and check data P (four symbols) of the C1 code are generated. For the C2 code, the Reed-Solomon code of 25, 20, 6 due to an interleave, in the lateral direction every four blocks is used to generate check data Q ($5 \times 4 = 20$ symbols) of the C2 code.

In the case of 12-bit data in the NTSC system, the size in the vertical direction is increased to be equal to 16-bit data as shown in Figure 4 to make the length in the lateral direction 3/4-ths. The length of the interleave in the horizontal direction is changed to be three, and for the C1 code and the C2 code, ones similar to the 16-bit data are used.

In the CCIR system, since the field frequency is 50 Hz, data of one field have 960 words in the case of a sampling frequency of 48 kHz. When the process is performed as an 8-bit symbol in two channels, 3840 symbols are provided. Consequently, the frame format of Figure 3 is employed. The longitudinal length is selected to be 48 symbols which is equal to the frame format of the NTSC system, and the horizontal size is selected to be 116 blocks. The interleave length in the horizontal direction is selected to be four, and as the C2 code, a Reed-Solomon code is employed.

In the case of 12-bit data, as shown in Figure 5, the horizontal length is selected to be 87 blocks, which is 3/4-ths as compared with the frame format of Figure 3. The interleave length of the C2 code is selected to be three, and a C2 code similar to the C2 code for the 16-bit data is used.

The present invention is application to any one of the frame formats of Figures 2 to 5. In the CCIR system, since the sampling frequency (48 kHz) can be divided by the field frequency, all the words can be arranged in the data area of the frame. Also, the present invention is applicable to the case where auxiliary data such as time code are inserted into a header in a CCIR system. The embodiment described below is the case where the invention is applicable to the frame format (Figure 2) of the 16-bit data in the NTSC system.

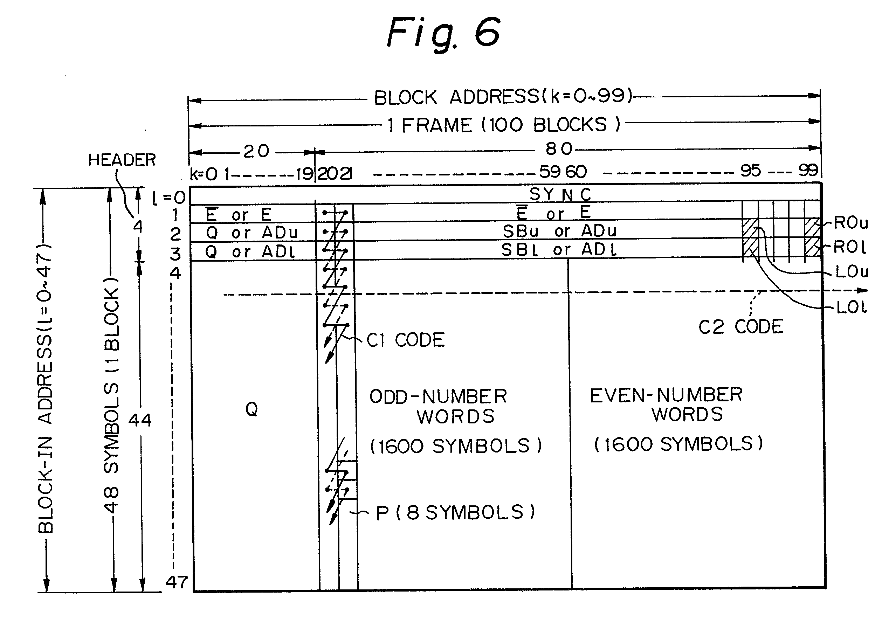

Figure 6 shows the frame format of Figure 2 in detail. One block is formed by 48 symbols arranged in the vertical direction. A header is disposed at the head of one block. The header comprises a synchronization signal (one symbol) and an error check code, for the data of the header, for example, check data E or $\bar{E}$ (one symbol) of a simple parity and check data Q of the C2 code, an upper (more significant) symbol ADu of an address signal, an upper symbol SBu of a sub-code or upper symbols LOu, ROu of audio data and the check data Q of the C2 code, a lower (less significant) symbol ADI of the address signal, and a lower symbol SBI of the sub-code or lower symbols LOI ROI of the audio

data. These data Q, ADu, ADl, SBu, LOu, ROu, SBl, LOl and ROl are inserted into the predetermined block selectively. A data area of 44 symbols is positioned after the header. The data area is made up of data (audio PCM signal), check data Q and check data P. One frame is formed by arranging the above-mentioned blocks of 100 columns in the lateral direction. Block-in addresses I of 0 to 47 are added to 48 symbols in the longitudinal direction of the matrix-shaped frame, and block addresses k of 0 to 99 are added to 100 blocks in the horizontal direction.

The audio PCM signal and check data P are contained in 44 symbols x 80 blocks of 20 to 99 of the block addresses k and 4 to 47 of the block-in addresses I. Since a video signal and a time-axis-compressed audio PCM signal are recorded onto a magnetic tape by a single scanning of the rotary heads, the amount of information of the audio PCM signal is contained in one field period. In the case of the sampling frequency of 48 kHz, the PCM audio signal of one field of the NTSC system are set to:

$$48,000 \times \frac{1}{59.94} = 800.8 \ (words).$$

As will be obvious from this equation, the sampling frequency cannot be divided by the field frequency. To solve this problem, in the frame format of Figure 6, the cases of both 800 words and 801 words which are recorded in mixed together fashion exist during a plurality of fields. However, in the following description of the code constitution, the frame format has 801 words. In the case of performing a linear digitization of 16 bits, each word is divided into an upper eight bits and a lower eight bits, and one symbol is set equal to eight bits.

Symbols LOu and ROu on the upper side of words L0 and R0 in the head of the audio PCM signals (L0 to L800, R0 to R800) of two channels, that is, left and right channels are inserted in positions of I = 2, k = 95 and I = 2, k = 99 as indicated by a shaded line. Also, symbols LOl and ROl on the lower side are inserted into positions of I = 3, k = 95 and I = 3, k = 99 as indicated by a shaded line. 1600 symbols of odd-number designated words among the remaining 800 words in each channel are arranged in k = 20 to 59, and 1600 symbols of even-number designated words are arranged in k = 60 to 99.

The check data Q of the C2 code is contained 20 blocks x 44 symbols of k = 0 to 19, I = 4 to 47. The C2 code is the 25, 20, 6 Reed-Solomon code which is formed for groups of twenty symbols, every four blocks of symbols of which are arranged in the horizontal direction. Since four series of this C2 code are formed with respect to one row, the check data Q of 4 x 5 = 20 symbols is contained in one row. As a result, the encoding processes of the C1 and C2 code is performed for all symbols of 44 symbols x 80 blocks of k = 20 to 99, I = 4 to 47.

However, encoding of the C1 code or the C2 code is not performed for a synchronization signal of I = 0, k = 0 to 99. For the check data E or $\bar{E}$ positioned at I = 1, k = 0 to 99, which are used for error detection of the data in the header, the encoding process of only the C1 code is performed, that is, the encoding process of the C2 code is not performed. As an error detection code, a simple parity is employed. A CRC code, etc, may be used without being limited to the simple parity.

In I = 2, k = 0 to 99, an upper symbols ADu of an address signal, an upper symbols SBu of a sub-code or upper symbols LOu, ROu of an audio PCM are contained corresponding to the block address. Specifically, in [I = 2, k = 4n + 0, 4n + 1, 4n + 2, (n = 0, 1, 2, ... 24)], the upper symbols ADu of the address signal is located, in [I = 2, k = 4n + 3, (n = 5, 6, 7 ... 22)], the upper symbol SBu of the sub-code is positioned, in [I = 2, k = 4n + 3, (n = 23, 24)], the upper symbols LOu, ROu of the PCM data are disposed. The encoding process of the C2 code is performed only for SBu and LOu, ROu in these data, and 5-symbol check data Q are disposed in the position [I = 2, k = 4n + 3, (n = 0, 1, 2, 3, 4)]. The encoding process of the C2 code is not performed with respect to an upper symbol ADu of the address signal.

In I = 3, k = 0 to 99, a lower symbol ADl of the address signal, a lower symbol SBl of the sub-code or lower symbols LOl, ROl of the sub-code are contained. A similar encoding process of the C2 code to the above-mentioned data of I = 2 is made with respect to this data except for the lower symbol ADl of the address signal. The sub-codes SBu, SBl are a time code which a user can employ, ID code of tape speed upon recording, ID code of stereo or bilingual, flag indicative of copy prohibition and so on.

As stated above, no address signal is contained in a block in which the encoding of the C2 code is made in the header. A header in which an address signal is contained and a header in which audio data or a sub-code is included and the C2 encoding is performed are distinguished by the check data E and inverted data $\bar{E}$.

The encoding process of the C1 code is performed for all blocks (100 blocks) except for the synchronization signal (block-in address I = 1 to 47). The C1 code is the Reed-Solomon code of 47, 43, 5. The series of the C1 code is constructed so as to exist in two adjacent blocks. That is, one C1 series is formed by the odd-number designated symbols of the block-in address of two adjacent blocks. Another C1' series is formed by the even-number designated symbols of the block-in address. The reason why the C1 sequence is formed so as to exist in two blocks is to prevent two symbols in one C1 series from becoming errors due to errors generated at the boundary of two sequential symbols upon recording.

The encoding by the C1 code is similar to the method described in US patent specification US-A-4 630 272. The check data P (eight symbols) of the C1 code of adjacent blocks are arranged in blocks having an odd-number of the range of (k ≧ 21) and are disposed in I = 40 to 47. The encoding process of the C1 code is not performed with respect to the blocks k = 0 to 19 in which the check data Q of the C2 code are included.

Upon reproduction, error detection and error correction are performed by the C1 code. A pointer is set for a block for which an error cannot be corrected, and error detection and error correction of the C2 code are made referring to the pointer. Additionally, upon reproduction, error detection on a header is performed by check data E and $\bar{E}$. These check data (referred to as a third redundant code) are generated respectively by adding (mod. 2) two symbols ADu and ADl which are located at k = 0, two symbols of parity Q at k = 19, two symbols SBu and SBl at k = 23, two symbols LOu and LOl at k = 95, and so on. On the reproduction side, a syndrome of a block, with the check data E added, has eight bits of all "0's" in the absence of an error, whereas a syndrome of a block, with the check data $\bar{E}$ added, has eight bits of all "1's" in the absence of an error. Due to the difference of the syndrome patterns, the difference in the content of the header can be detected.

B. One Example of a Data Interleave

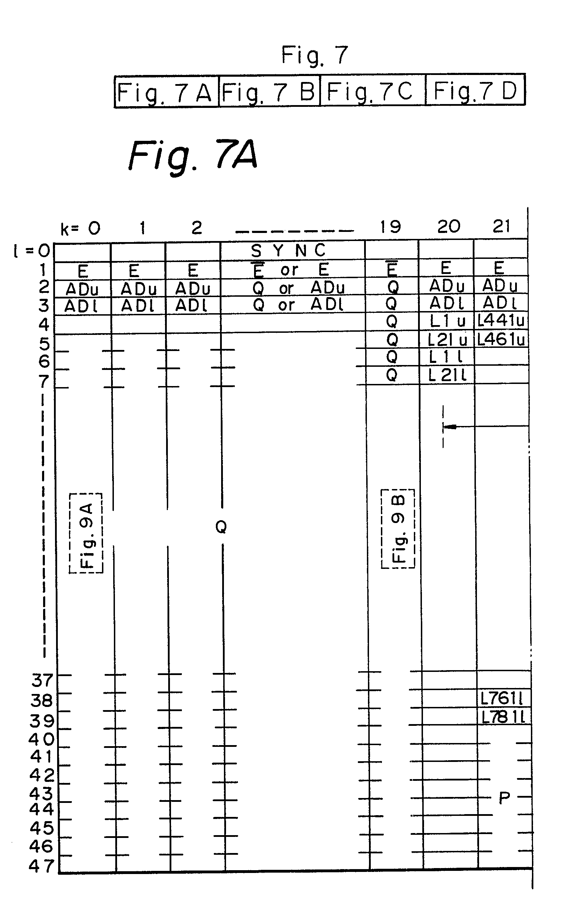

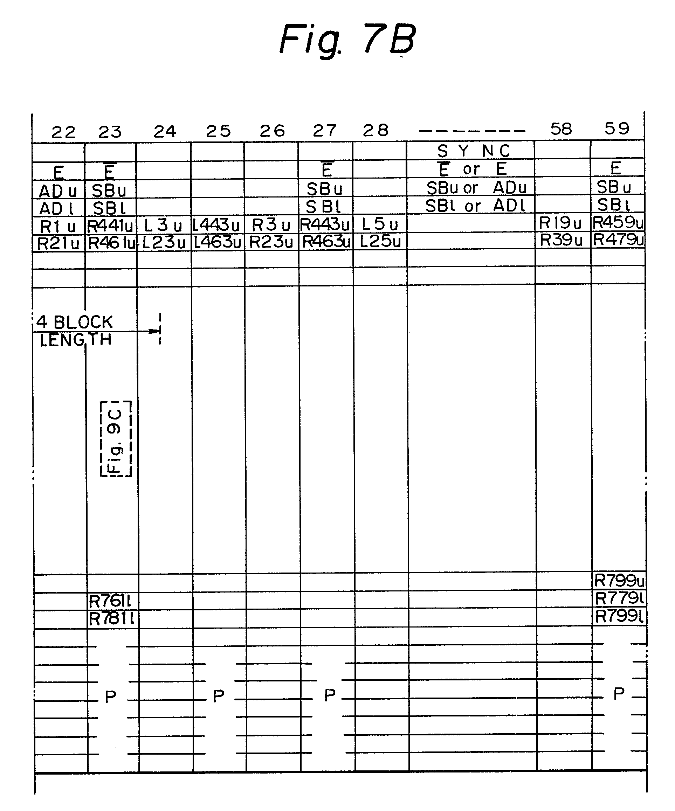

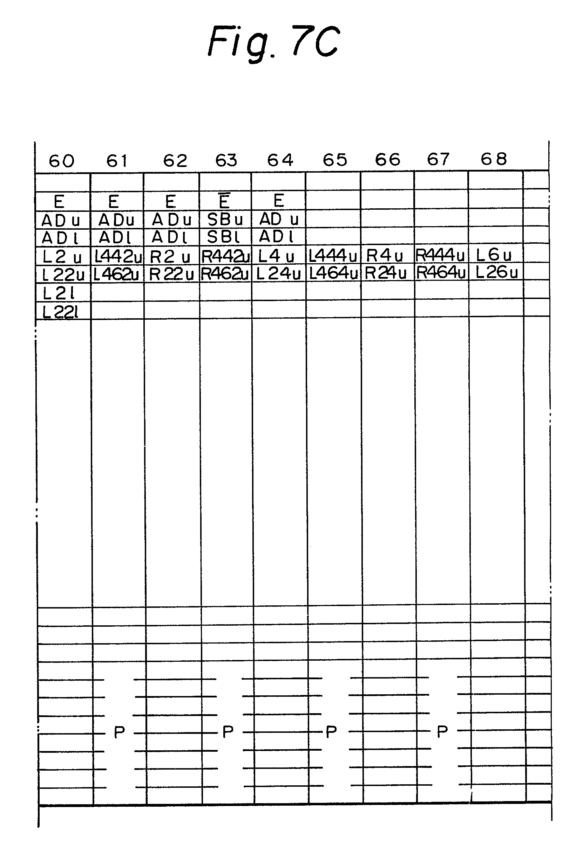

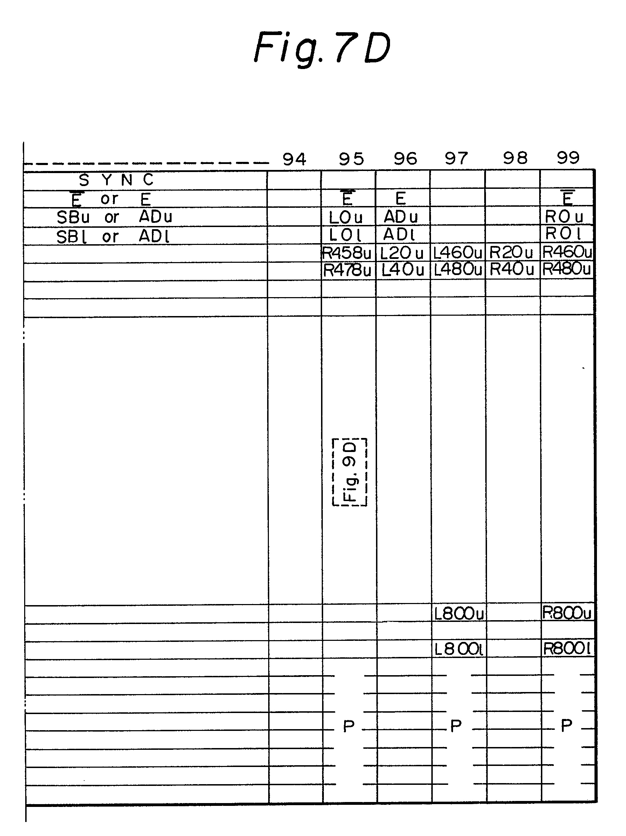

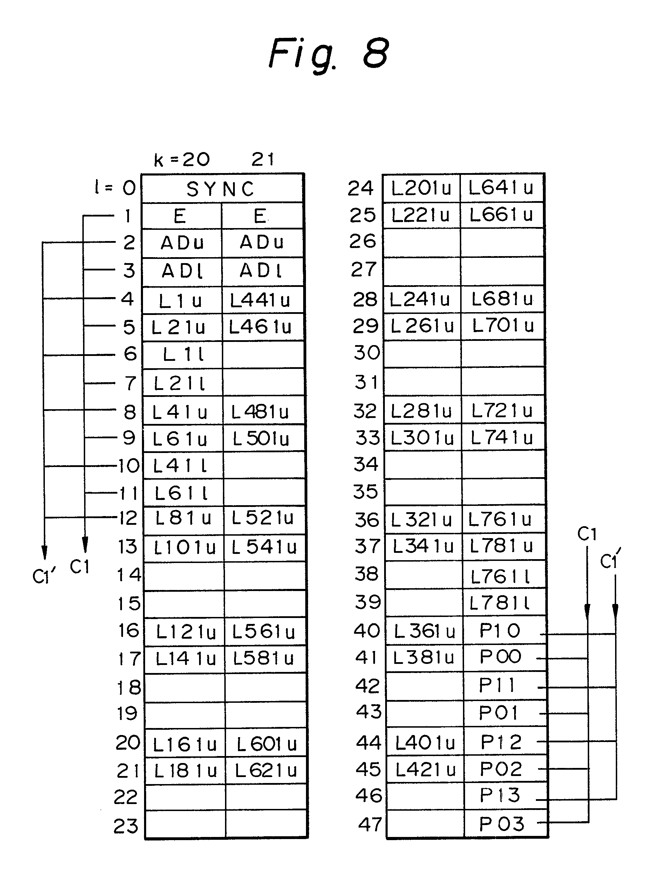

Figures 7 and 8 show an interleave of data of 801 words (3204 symbols in two channels) of one field of the NTSC system in detail. Figures 7A and 7B shows a data format in the block addresses k = 0 to 59, Figures 7C and 7D indicate k = 60 to 99, and Figure 8 shows those in the block addresses k = 20, k = 21 in detail.

As mentioned above, four symbols (LOu, LOl, ROu, ROl) of two words are positioned in l = 2 and 3 at k = 95 and 99. The odd-number designated words L1 to L799, R1 to R799 are arranged in l = 4 to 47 at k = 20 to 59. The even-number designated words L2 to L800, R2 to R800 are arranged in l = 4 to 7 at k = 60 to 99. By separating the recording positions of the even-number designated words and odd-number designated words, the poor effect caused upon reproduction when successive words are in error can be reduced.

An example of the interleave of the symbols of the odd-number designated words will now be described. As shown in Figures 7A and 8, data are sequentially arranged from l = 4, l = 6. In this case, symbols (L1u, R1u, L3u, R3u, ... R19u) on the upper side are arranged in the even number designated block addresses (k = 20, 22, 24, 26 ... 58) in l = 4. The symbols (L1l, R1l, L3l, R3l, ... R19l) on the lower side are sequentially arranged in the even-number designated block addresses (k = 20, 22, 24, 26, ... 58) of an even-number of l = 6. The next odd-number designated symbols are arranged in l = 5, l = 7 in a manner similar to the above. By repeating the data arrangement in this manner, R799u and R799l are located in k = 59, l = 37 and 39.

In Figure 8, P00 to P13 denote C1 parities regarding two blocks of k = 20 and 21. That is, in the two blocks, parities of the C1 code P00, P01, P02, P03 are formed by the 47 symbols located in the odd-number designated block-in addresses. The parities of the C1' code P10, P11, P12, P13 are formed by the 47 symbols located in the even-number designated block-in addresses.

The even-number designated words are arranged as shown in Figures 7C and 7D in a manner similar to the odd-number designated words. The symbols R800u and R800l of the last word in the R channel are arranged in k = 9, l = 37 and 39. With the interleave shown in Figures 7 and 8, in each of the even-number designated word series and odd-number designated word series in each channel, the recording positions of adjacent words are interleaved by four blocks. Successive recording of the upper side symbol and the lower side symbol of one word is prevented, and the influence of burst errors is reduced.

C. Format of a Block

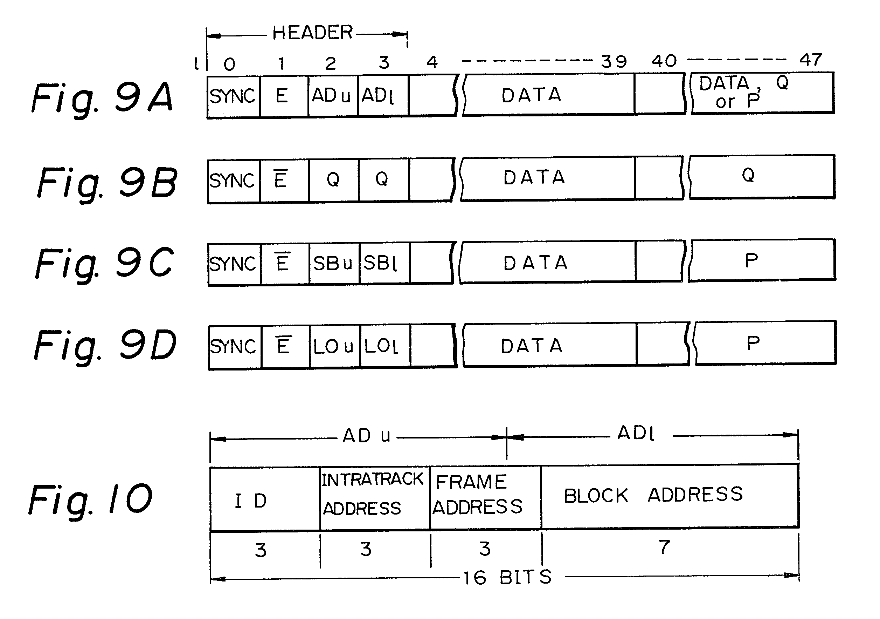

Figures 9A to 9D shows blocks formed by each column (vertical direction) in the above-described frame format as shown in Figures 7A, 7B and 7D. Blocks whose block addresses k are [k = 4n + 0, 4n + 1, 4n + 2, (n = 0, 1, 2, ... 24)] have a data format as shown in Figure 9A. Blocks of [k = 4n + 3, (n = 5, 6, 7, ... 22)] have a data format as shown in Figure 9C. Blocks of [k = 4n + 3, (n = 23)] have a data format shown in Figure 9D. Although not shown, the block of [k = 4n + 3, (n = 24)] is the one which has inserted ROu and ROl in place of data LOu and LOl of Figure 9D.

The block shown in Figure 9A and the blocks shown in Figures 9B, 9C and 9D are distinguished based upon whether an address signal is contained in the header. Therefore, check data of the block (Figure 9A) containing the address signal is treated as original data E and check data of the block (Figures 9B, 9C and 9D) containing no address signal are treated as $\bar{E}$.

Figure 10 shows the contents of an address signal comprising an upper symbol ADu and a lower symbol ADl. The upper three bits in the upper symbol ADu are used as an identification code ID for searching for a required scene in a tape, and the subsequent three bits (INTRATRACK ADDRESS) are used as a block-in address. The block-in address is employed for the channel identification when one track is divided into six channels, as disclosed in US patent specification US-A-4 542 419. The next three bits are used as a frame address. The frame address is employed for selecting a required frame (track) upon high speed reproduction where the scanning of a rotary head is performed over a plurality of tracks. A block address k is indicated by the lower seven bits in the lower symbols ADl. With respect to blocks into which the block addresses are not inserted, the correct block addresses can be reproduced by interpolation using the block addresses of the blocks lying before and after the block.

The above-mentioned identification code is used to identify the number of words contained in the frame format of the codes. Since 800 or 801 words per channel are included in the frame format in this embodiment, an identification code is used to distinguish both.

Since audio data of 40 symbols at the maximum can be inserted into a header, it is possible to set an asynchronous state absorbing margin of ten words at the maximum per channel without being limited to the case where an asynchronous state absorbing margin of one word per channel is set, as in the above-mentioned embodiment. The foregoing margin is necessary in order to absorb the asynchronization between the video image and the audio sound which is caused by there being no integral ratio between the sampling frequency and the field frequency.

### D. PCM Recording Processing Circuit

This invention is applicable to a rotation head-type VTR which records a video signal and a PCM audio signal onto a magnetic tape by single scanning. A pair of rotary heads having an angular interval of 180° therebetween and rotated at a frame frequency (29.97 Hz in the case of the NTSC system) are mounted inside a drum. The heads may be magnetic heads. The magnetic tape is run obliquely at constant speed over the angular range of equal to or larger than 210°, with respect to its rotational circumference. In this case, the rotation phases of the rotary heads are controlled so as to synchronize with the video signal to be recorded and the rotary heads are servo-controlled so as to scan the track correctly upon reproduction.

Therefore, with the scanning of each rotary head, a video section and a PCM section are formed. The frequency multiplexed signal of an FM luminance signal, a lower frequency band converted carrier chrominance signal, an FM audio signal and a pilot signal is recorded in the video section. Also, with respect to stereo audio signals L and R, the processing of error correction encoding and the processing of time-axis compression are performed by a PCM recording processing circuit. The output signal of the PCM recording processing circuit is recorded in a PCM section.

Meanwhile, upon reproduction, the frequency multiplexed signal and the PCM signal are alternately reproduced by the rotary heads. The reproduced frequency multiplexed signal is supplied to a video reproduction and processing circuit, and the PCM signal is supplied to a PCM reproduction processing circuit. A reproduced colour video signal and stereo audio signals L and R are derived from these reproduction and processing circuits.

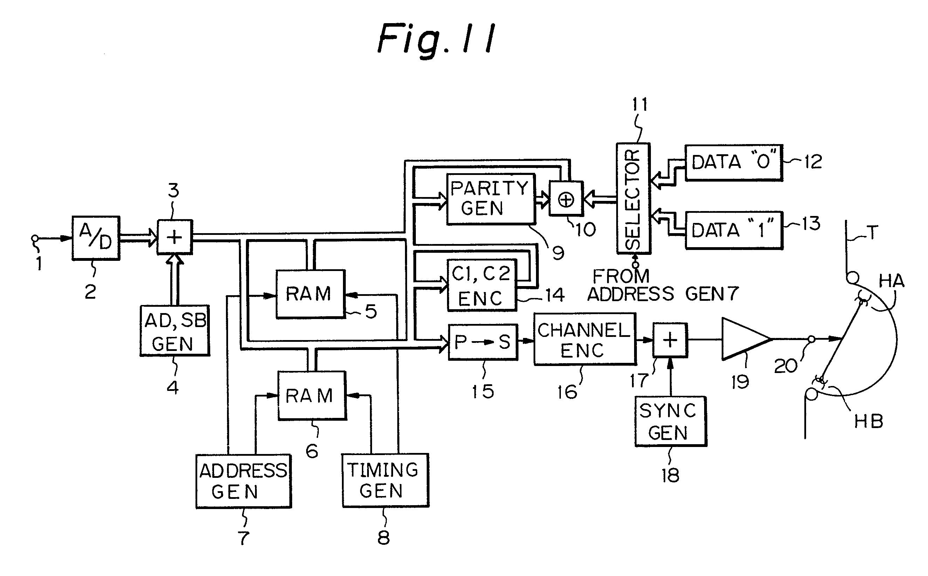

An example of the PCM recording processing circuit will be described with reference to Figure 11. An analogue audio signal from a terminal 1 is supplied to an input terminal of an analogue-to-digital (A/D) converter 2 where the analogue audio signal is converted into a PCM signal. The output data of the A/D converter 2 are supplied to an adder 3. The address signal and the sub-code are supplied to the adder 3 from an address and sub-code generator 4, and are added to the PCM audio signal.

The output signal from the adder 3 is used as the data inputs to RAMs 5 and 6. Each of the RAMs 5 and 6 has a capacity sufficient to store the symbols of one frame. An address generating circuit 7 and a timing generating circuit 8 are provided in conjunction with the RAMs 5 and 6 and are controlled so as to write and read-out data into and from the RAMs 5 and 6 on a symbol unit basis. Two RAMs 5 and 6 are employed, so that during the time when data are written into one of the RAMs, data are read out from the other RAM and error correction encoded. Also, time-axis compression processing with a compression ratio of 1/6 is effected by the RAMs 5 and 6.

The PCM audio signal read out from one of the RAMs 5 and 6 is supplied to an encoder 14 of the C1 and C2 codes, and the parities of the C1 and C2 codes are formed. The parities are written into either one of the RAMs 5 and 6. A parity generating circuit 9 is provided, and check data E of an error detection code for two symbols included in a header of each block are generated. The check data E are supplied to a mod-2 adder 10. The output of a "0" data generating circuit 12 or the output of a "1" data generating circuit 13 is supplied to the adder 10 through a selector 11. The selector 11 selectively supplies one of "0" data or "1" data depending on a block address from the address generating circuit 7.

Specifically, in the case of the block with the format as shown in Figure 9A, the "0" data are selected by the selector 11, and in the case of blocks with the format as shown in Figures 9B, 9C and 9D, the "1" data are selected by the selector 11. When the "0" data are supplied to the adder 10, no alteration is made to the check data E. When the "1" data are supplied to the adder 10, the check code E is inverted. The check code E or $\overline{E}$ is added to the block. After completion of the error correction encoding process, the digital signals consisting of check data, block address, sub-code and data are read out from the RAMs 5 and 6, block by block, and they are supplied to a parallel-to-serial converter 15 where they are converted into serial data.

The output data from the parallel-serial converter 15 is supplied to a channel encoder 16. The channel encoder 15 is a 8-to-10 modulator for converting 8-bit data into 10-bit data, so as to reduce the direct current component of the data sequence irrespective of the data content. The channel encoder 16 comprises a ROM storing a data conversion map. The output signal of the channel encoder 16 is supplied to a second adder 17, and in the second adder 17, a block synchronization signal from a synch generator 18 is added to the output signal and is derived as a PCM signal at an output terminal 10 via a recording amplifier 19. This output signal is recorded onto a magnetic tape T by rotary heads HA and HB. The magnetic tape T is wrapped obliquely around the peripheral surface of a drum over an angular range of 210°.

### E. Modifications

In this embodiment 800 and 801 have been used as two types of numerical value data. However, it is also possible to use numerical values of, for example, 800 and 802 which are close to the quotient obtained when the sampling frequency fs is divided by the field frequency. On the other hand three or more kinds of numerical values can also be selective used thereby not being limited to two kinds.

This invention is applicable to the case where a frame of error correction codes is comprised of a unit of one word or two words of L and R. In the invention, error correction codes other than Reed-Solomon codes can be used.

Embodiments of this invention can prevent the increase of redundancy due to the addition of an address signal with respect to all blocks. In addition, such embodiments enable the formation of a plurality of contents as headers containing a synchronization signal and an address signal other than a digital information signal. Therefore, the digital information signal, a sub-code, etc, can be inserted in place of the address signal. As a result, by inserting the digital information signal into the header, the recording of a number of words, which, on an average, is equal to the quotient obtained when the sampling frequency is divided by the field frequency, can be performed. The occurrence of asynchronization between a video image and audio sound can be prevented. Further, to distinguish the difference of the content of the block, there is employed a redundant code of an error detection code of a header which forms a redundant code so that values of syndromes are different. For this reason, the processing of an 8-bit-unit can be performed in contrast to the allotment of one bit of a redundant code to an identification. Also, another advantage is that the kinds which can be distinguished are not limited to multiples of two.

## Claims

1. A digital signal transmission apparatus for transmitting a digital signal having a header of a predetermined length, wherein said header comprises:
a synchronization signal; and
an auxiliary data signal comprising an error code data signal and a redundant code, said error code data signal being selected from a first error code data signal and second error code data signal;
said redundant code having a syndrome pattern associated with said error code data signal which indicates which of said first error code data signal and said second error code data signal is comprised in said auxiliary data signal.

2. A digital signal transmission apparatus for transmitting a digital signal, wherein said digital signal comprises:
a two-dimensional array of digital data information signals, having a horizontal direction and a vertical direction, and wherein a first error detection code is encoded in said vertical direction to form a first redundant code, and a second error detection code is encoded in said horizontal direction to form a second redundant code, said first and second error detection codes having a syndrome pattern respectively associated therewith; and including:
means (10) for adding a header comprising a synchronization signal and an auxiliary data signal to said digital signal, wherein said auxiliary data signal comprises an error code data signal and a third redundant error detection code, the error code data signal is selected from a first error code signal and a second error code signal wherein said error code data signal is encoded with said first error detection code when said error code data signal is said first error code data signal, and said error code data signal is encoded with said first error detection code and said second error detection code when said error code data signal is said second error code data signal, and wherein said third redundant code is formed so that said syndrome pattern distinguishes said auxiliary data signal including said first error code signal from said auxiliary data signal including said second error code signal.

3. Apparatus according to claim 2 wherein said first error code signal forming said auxiliary data signal is an address signal, and said second error code signal is a sub-code or said second redundant code.

4. Apparatus according to claim 2 wherein said first error code signal forming said auxiliary data signal is an address signal, and said second error code signal is a sub-code, said second redundant code, or a digital information signal.

5. A digital data recording and reproduction apparatus comprising:
an A/D converter (2) for converting an analogue input signal having a field frequency associated therewith into a digital data signal having a sampling frequency associated therewith;
an encoder (14) for adding an error correction code to said digital data signal to generate an encoded digital data signal; and
means (HA, HB) for magnetically recording said encoded digital data signal onto a magnetic tape (T) having at least one track, said means (HA, HB) for magnetically recording having rotational magnetic heads (HA, HB), wherein:
said encoder (14) generates said error correction code, said error correction code has a data frame arranged as a two-dimensional array having a preselected size, said array size including at least a first word number and a second word number, each of said first and second word numbers being an integral value determined by said sampling frequency of said digital data signal divided by said field frequency; said data frame has a first plurality of blocks and a second plurality of blocks, said first plurality of blocks comprises a pulse code modulated audio data area and said second plurality of blocks comprises a header area, said header area being composed of a synchronization signal and auxiliary data;
said auxiliary data comprise an error code data signal and a redundant code, said error code data signal being a first error code data signal or a second error code data signal; and
said redundant code indicates the error code data signal selected, and said redundant code has a syndrome pattern associated therewith to distinguish said error code data signal selected.

6. A digital data recording and reproduction apparatus, comprising:

an A/D converter (2) for converting an analogue input signal having a field frequency associated therewith into a digital data signal having a sampling frequency associated therewith;

an encoder (14) for adding an error correction code to said digital data signal, said encoder (14) generating an encoded digital data signal; and

means (HA, HB) for magnetically recording said encoded digital data signal onto a magnetic tape (T) having at least one track, said means (HA, HB) for magnetically recording having rotational magnetic heads (HA, HB);

said encoder (14) having a data frame arranged as a two-dimensional array having a preselected size, said array size including at least a first word number and second word number, said first and second word numbers being an integral value determined by said sampling frequency of said digital data signal divided by said field frequency;

said two-dimensional array having a vertical direction and a horizontal direction and comprising a plurality of digital data information signals, a first error detection code encoded in the vertical direction to form a first redundant code, a second error detection code encoded in the horizontal direction to form a second redundant code, and a header comprised of a synchronization signal and an auxiliary data signal;

said auxiliary data signal comprising a third redundant code and an error code selected from a first error code data signal and a second error code data signal;

said first error code data signal is encoded with said first error detection when said auxiliary data signal comprises said first error code data signal and said second error code data signal is encoded with said first error detection code and said second error detection code when said auxiliary data signal comprises said second error code data signal; and

said third redundant code has a syndrome pattern associated therewith, said syndrome pattern indicating which of said first error code date signal and said second error code data signal is comprised in said auxiliary data signal.

7. Apparatus according to claim 5 or claim 6 wherein said first error code data signal forming said auxiliary data is an address signal, and said second error code data signal is a sub-code or said second redundant code.

8. Apparatus according to claim 5 or claim 6 wherein said first error code data signal forming said auxiliary data is an address signal, and said second error code data is a sub-code, a digital audio information signal, or said second redundant code.

9. Apparatus according to claim 5 or claim 6 wherein said digital data are an audio information signal, and further comprising:

means (5, 6) for compressing said audio information signal to generate a compressed audio information signal; and wherein:

said means (HA, HB) for magnetically recording sequentially records said compressed audio information signal and said video signal onto one of said tracks of said magnetic tape (T).

10. Apparatus according to claim 9 wherein said video signal is an NTSC colour television signal, said sampling frequency is 48 kHz, and said first word number and said second word number are 800 to 801, respectively.

11. Apparatus according to claim 5 or claim 6 wherein said syndrome pattern is a sequence of zero bits when no error exists in said header.

12. Apparatus according to claim 5 or claim 6 wherein said syndrome pattern is a sequence of one bits when no error exists in said header.

EP 0 349 325 A2

## Fig. IA

1 BLOCK

HEADER

| SYNC | ADDRESS | CRCC | DATA | |
|------|---------|------|------|---|

→ C1 ENCODING

→ C2 ENCODING

## Fig. IB

| SYNC | ADDRESS | CRCC | DATA | |
|------|---------|------|------|---|

→ C1 ENCODING

→ C2 ENCODING

## Fig. IC

ADDRESS/ERROR CODE/ SUB-DATA

| SYNC | | DATA | |
|------|---|------|---|

→ C1 ENCODING

→ C2 ENCODING

# Fig. 2

NTSC SYSTEM (16 BITS)

# Fig. 3

CCIR SYSTEM (16 BITS)

## Fig. 4

75 BLOCKS

15 60

SYNC

1

4

HEADER

DATA
(3 SYMBOLS)

3

C2

1 BLOCK
(48 SYSTEMS)

40

Q

C1

DATA
(2400 SYMBOLS)

4

P

NTSC SYSTEM (12 BITS)

## Fig. 5

15 72

SYNC

4

HEADER

3

C2

40

Q

C1

P

4

CCIR SYSTEM (12 BITS)

## Fig. 6

BLOCK ADDRESS (k=0~99)

1 FRAME (100 BLOCKS)

20 — 80

k=0 1 --- 19 20 21 --- 59 60 --- 95 --- 99

SYNC

ROu
ROl
LOu
LOl

$\overline{E}$ or E — SBu or ADu — SBl or ADl

$\overline{E}$ or E — Q or ADu — Q or ADl

C2 CODE

EVEN-NUMBER WORDS (1600 SYMBOLS)

C1 CODE

ODD-NUMBER WORDS (1600 SYMBOLS)

P (8 SYMBOLS)

Q

l=0 1 2 3 4 --- 47

HEADER

4 4 44

48 SYMBOLS (1 BLOCK)

BLOCK-IN ADDRESS (l=0~47)

Fig. 7

| Fig. 7 A | Fig. 7 B | Fig. 7C | Fig. 7 D |
|---|---|---|---|

## Fig. 7A

| | k= 0 | 1 | 2 | — — — — — — — | 19 | 20 | 21 |
|---|---|---|---|---|---|---|---|
| l = 0 | | | | S Y N C | | | |
| 1 | E | E | E | $\bar{E}$ or E | $\bar{E}$ | E | E |
| 2 | ADu | ADu | ADu | Q or ADu | Q | ADu | ADu |
| 3 | ADl | ADl | ADl | Q or ADl | Q | ADl | ADl |
| 4 | | | | | Q | L1 u | L441u |
| 5 | | | | | Q | L2l u | L461u |
| 6 | | | | | Q | L 1 l | |
| 7 | | | | | Q | L 2l l | |
| | | | | | | | |
| | Fig. 9A | | | Q | Fig. 9 B | | |
| 37 | | | | | | | |
| 38 | | | | | | | L761l |
| 39 | | | | | | | L78 1l |
| 40 | | | | | | | |
| 41 | | | | | | | |
| 42 | | | | | | | |
| 43 | | | | | | | P |
| 44 | | | | | | | |
| 45 | | | | | | | |
| 46 | | | | | | | |
| 47 | | | | | | | |

# Fig. 7B

| 22 | 23 | 24 | 25 | 26 | 27 | 28 | ------- | 58 | 59 |
|---|---|---|---|---|---|---|---|---|---|
| | | | | | | | S Y N C | | |
| E | Ē | | | | Ē | | Ē or E | | E |
| ADu | SBu | | | | SBu | | SBu or ADu | | SBu |
| ADl | SBl | | | | SBl | | SBl or ADl | | SBl |
| R1u | R441u | L3u | L443u | R3u | R443u | L5u | | R19u | R459u |
| R21u | R461u | L23u | L463u | R23u | R463u | L25u | | R39u | R479u |
| | | | | | | | | | |
| | | | | | | | | | |
| 4 BLOCK LENGTH | | ⊢→ | | | | | | | |
| | Fig. 9C | | | | | | | | |
| | | | | | | | | | R799u |
| | R76ll | | | | | | | | R779l |
| | R78ll | | | | | | | | R799l |
| | P | | P | | P | | | | P |

# Fig. 7C

| 60 | 61 | 62 | 63 | 64 | 65 | 66 | 67 | 68 | |
|----|----|----|----|----|----|----|----|----|----|
| | | | | | | | | | |
| E | E | E | E̅ | E | | | | | |
| AD u | AD u | AD u | SB u | AD u | | | | | |
| AD l | AD l | AD l | SB l | AD l | | | | | |
| L2 u | L442u | R2 u | R442u | L4 u | L444u | R4 u | R444u | L6 u | |
| L22u | L462u | R22 u | R462u | L24u | L464u | R24 u | R464u | L26 u | |
| L2 l | | | | | | | | | |
| L22l | | | | | | | | | |
| | | | | | | | | | |
| | | | | | | | | | |
| | | | | | | | | | |
| | | | | | | | | | |
| | | | | | | | | | |
| | P | | P | | P | | P | | |

## Fig.7D

| | 94 | 95 | 96 | 97 | 98 | 99 |
|---|---|---|---|---|---|---|
| S Y N C | | | | | | |
| $\overline{E}$ or $E$ | | $\overline{E}$ | $E$ | | | $\overline{E}$ |
| SBu or ADu | | LOu | ADu | | | ROu |
| SBl or ADl | | LOl | ADl | | | ROl |
| | | R458u | L20u | L460u | R20u | R460u |
| | | R478u | L40u | L480u | R40u | R480u |
| | | | | | | |
| | | | Fig. 9D | | | |
| | | | | L800u | | R800u |
| | | | | L800l | | R800l |
| | | P | | P | | P |

# Fig. 8

| l = | k =20 | 21 |
|---|---|---|
| 0 | SYNC | |
| 1 | E | E |
| 2 | ADu | ADu |
| 3 | ADl | ADl |
| 4 | L 1 u | L441u |
| 5 | L 21u | L461u |
| 6 | L 1 l | |
| 7 | L 21 l | |
| 8 | L 41 u | L481u |
| 9 | L 61 u | L501u |
| 10 | L 41 l | |
| 11 | L 61 l | |
| 12 | L 81 u | L521u |
| 13 | L101u | L541u |
| 14 | | |
| 15 | | |
| 16 | L121u | L561u |
| 17 | L141u | L581u |
| 18 | | |
| 19 | | |
| 20 | L161u | L601u |
| 21 | L181u | L621u |
| 22 | | |
| 23 | | |

C1′  C1

| | k=20 | 21 |
|---|---|---|
| 24 | L201u | L641u |
| 25 | L221u | L661u |
| 26 | | |
| 27 | | |
| 28 | L241u | L681u |
| 29 | L261u | L701u |
| 30 | | |
| 31 | | |
| 32 | L281u | L721u |
| 33 | L301u | L741u |
| 34 | | |
| 35 | | |
| 36 | L321u | L761u |
| 37 | L341u | L781u |
| 38 | | L761 l |
| 39 | | L781 l |
| 40 | L361u | P10 |
| 41 | L381u | P00 |
| 42 | | P11 |
| 43 | | P01 |
| 44 | L401u | P12 |
| 45 | L421u | P02 |
| 46 | | P13 |
| 47 | | P03 |

C1  C1′

Fig. 9A

Fig. 9B

Fig. 9C

Fig. 9D

Fig. 10

EP 0 349 325 A2

Fig. 11